# EUROPEAN PATENT APPLICATION

(11) **EP 4 432 702 A1**
(43) Date of publication of application: **18.09.2024**
(21) Application number: 23216027.5
(22) Date of filing: 12.12.2023
(51) Int. Cl.: H04R 9/00

(54) **DYNAMIC SPEAKER COILS AS RADIO FREQUENCY ANTENNAS IN MOBILE COMPUTING DEVICES**

(30) Priority: 14.03.2023 US 202318121315
(71) Applicant: INTEL Corporation, Santa Clara, CA 95054 (US)
(72) Inventor: WAGHELA, Yagnesh, 560049 Bangalore (IN); CHERUKKATE, Sumod, 560095 Bangalore (IN); GUPTA, Sagar, 201002 Ghaziabad (IN); MANJA, Sudhakar Arehole Narayana, 560070 Bangalore, Karnataka (IN); MISHRA, Soumya Prakash, 751002 Bhubaneswar (IN); Subramanya, Bala, 560016 Bangalore (IN); THAKUR, Jayprakash, 560035 Bangalore (IN)
(74) Representative: 2SPL Patentanwälte PartG mbB

(57) **Abstract**

The speaker coil in a dynamic speaker in a mobile computing device can be used to generate radio frequency (RF) signals having a frequency of about 100 kHz or greater. A speaker amplifier drives the dynamic speaker to produce sound and RF circuitry drives the speaker amplifier to generate the RF signals having a frequency of about 100 kHz or greater. The speaker coil can comprise a tap at an appropriate point between the ends of the coil to cause the coil to operate at resonance over a desired RF frequency band. A low-pass filter can be positioned at the speaker amplifier output to protect the speaker amplifier from RF energy generated by the RF circuitry and a high-pass filter can be positioned at the output of the RF circuitry to protect the RF circuitry from audio energy generated by the speaker amplifier.

## Description

### BACKGROUND

Mobile computing devices (e.g., laptops, tablets, smartphones, wearables) can comprise multiple antennas to enable various device functions. For example, some existing smartphones comprise multiple antennas to enable in a combination of cellular, Wi-Fi, Bluetooth, GPS (Global Positioning System), and NFC (Near-Field Communications) functions.

### BRIEF DESCRIPTION OF THE DRAWINGS

FIGS. 1A-1B are simplified cross-sectional views of example dynamic speakers that can be utilized as RF antennas.
FIG. 2 illustrates a simplified top view of an example speaker module having a low z-profile that can be used as an RF antenna in mobile computing devices.
FIG. 3 is a schematic diagram of a first circuit comprising an example dynamic speaker that can be used as an RF antenna.
FIG. 4 is a schematic diagram of a second circuit comprising an example dynamic speaker that can be used as an RF antenna.
FIG. 5 is a graph showing return loss versus frequency for an example tablet coil for an example tablet computing device.
FIG. 6 is a graph showing return loss versus frequency for an example speaker coil for an example laptop computing device.
FIG. 7 is an example method of utilizing a dynamic speaker to produce sound, and to transmit and receive RF signals having a frequency greater than about 100 kHz.
FIG. 8 is a block diagram of an example computing system within which the technologies described herein can be utilized.
FIG. 9 is a block diagram of an example processor unit to execute computer-executable instructions as part of implementing technologies described herein.

### DETAILED DESCRIPTION

Mobile computing devices, such as laptops, tablets, smartphones, and wearables, are becoming more compact and thinner in successive generations. Implementing desired product features in such devices without compromising battery capacity can be a challenge for device designers. One opportunity to increase the space available in a mobile computing device that can be used for a battery is to reduce the number of antennas in the device.

In devices that implement radio frequency (RF) identification (RFID) technologies, an RF antenna is used to enable communication between the device and an RFID reader. RFID technologies can be used for identifying mobile computing devices while they are in a poweredoff state, which can be useful for inventory management, tracking devices during shipping, etc. RFID functionality can be implemented in a mobile computing device as a separate component (such as an RFID tag), one or more components that are integrated onto a motherboard, or integrated into an integrated circuit component (such as a system-on-a-chip (SOC)). RFID tags can be passive or active. Active RFID tags comprise a power source, which can be a dedicated battery for powering the RFID tag or a power source used by the mobile computing device within which the RFID tag is located (e.g., a battery). Passive RFID tags do not have a power source and are powered by RF energy transmitted by an RFID reader.

Disclosed herein are mobile computing devices that use the coil of a dynamic speaker to generate sound, and to transmit and receive radio frequency (RF) signals that have a frequency greater than about 100 kHz. As used herein, the term "sound" refers to transmitted audio signals that have a frequency in the frequency range that can be heard by humans, which is about 20 Hz to about 20 kHz. A speaker amplifier and an RF circuit conductively coupled to a dynamic speaker cause the speaker to produce sound, and to transmit and receive RF signals with frequencies greater than about 100 kHz, respectively. The speaker amplifier can comprise a low-pass filter to protect the speaker amplifier from the RF signals produced by the RF circuit, and the RF circuitry can comprise a high-pass filter to protect the RF circuit from audio signals produced by the speaker amplifier. In some embodiments, the RF circuit and the dual speaker amplifier outputs are conductively coupled to the same pair of speaker inputs conductively coupled to ends of the speaker coil. In other embodiments, the RF circuit can connect to a third speaker input that is conductively coupled to a point along the speaker coil between the ends of the speaker coil to enable efficient RF signal transmission by the speaker coil within a desired RF frequency band.

The mobile computing devices disclosed herein comprising dynamic speakers that can produce sound, and transmit and receive RF signals with frequencies greater than about 100 kHz have at least the following advantages. First, by eliminating the need for a separate RF antenna, the number of antennas in the mobile computing device is reduced, which can create space for other components. For example, in some existing mobile computing devices, an RFID antenna can consume about 1500 sq. mm of printed circuit board area. Reallocating this space for battery usage can increase the battery capacity in these devices by about 5-10%. Second, the reduced number of antennas can reduce BOM (bill of materials) costs for such computing devices. Third, the addition of a low-pass filter to the output stage of a speaker amplifier (if the speaker amplifier does not already have a low-pass filter to limit EMI (electromagnetic interference) emissions) and a high-pass filter to the RF circuit is inexpensive, in terms of real estate and cost, to a system design. The addition low-pass and high-pass passive filters to a mobile computing system may result in an increase of BOM costs by no more than ten cents. Fourth, there is no or little concern of cross-coupling between the sound produced by the dynamic speaker and the RF signals generated by the speaker coil due to their non-overlapping frequency bands. The audio signals are less than about 20 kHz and the RF signals have a frequency greater than about 100 kHz.

In the following description, specific details are set forth, but embodiments of the technologies described herein may be practiced without these specific details. Well-known circuits, structures, and techniques have not been shown in detail to avoid obscuring an understanding of this description. Phrases such as "an embodiment," "various embodiments," "some embodiments," and the like may include features, structures, or characteristics, but not every embodiment necessarily includes the particular features, structures, or characteristics.

Some embodiments may have some, all, or none of the features described for other embodiments. "First," "second," "third," and the like describe a common object and indicate different instances of like objects being referred to. Such adjectives do not imply objects so described must be in a given sequence, either temporally or spatially, in ranking, or any other manner. "Connected" may indicate elements are in direct physical or electrical contact with each other and "coupled" may indicate elements co-operate or interact with each other, but they may or may not be in direct physical or electrical contact. As used herein, the phrase "conductively coupled" refers to components that are coupled to facilitate the flow of current between them. One or more components can be positioned between, from a circuit topology standpoint, two components that are conductively coupled. For example, an output of a speaker amplifier connected to an input of a dynamic speaker by one or more printed circuit board traces and a low-pass filter between the speaker amplifier and the dynamic speaker are conductively coupled. Furthermore, the terms "comprising," "including," "having," and the like, as used with respect to embodiments of the present disclosure, are synonymous. Moreover, a stated value for a dimension, feature, or characteristic qualified the term "about" includes values within +/-10% of the stated value. Similarly, a stated range of values for a dimension, feature, or characteristic includes values within 10% of the listed upper and lower values for the range.

In the following description, for purposes of explanation, specific details are set forth to provide a thorough understanding thereof. It may be evident, however, that the novel embodiments can be practiced without these specific details. In other instances, well known structures and devices are shown in block diagram form to facilitate a description thereof. The intention is to cover all modifications, equivalents, and alternatives within the scope of the claims

As used herein, the term "integrated circuit component" refers to a packaged or unpacked integrated circuit product. A packaged integrated circuit component comprises one or more integrated circuit dies mounted on a package substrate with the integrated circuit dies and package substrate encapsulated in a casing material, such as a metal, plastic, glass, or ceramic. In one example, a packaged integrated circuit component contains one or more processor units mounted on a substrate with an exterior surface of the substrate comprising a solder ball grid array (BGA). In one example of an unpackaged integrated circuit component, a single monolithic integrated circuit die comprises solder bumps attached to contacts on the die. The solder bumps allow the die to be directly attached to a printed circuit board. An integrated circuit component can comprise one or more of any computing system component described or referenced herein or any other computing system component, such as a processor unit (e.g., system-on-a-chip (SoC), processor core, graphics processor unit (GPU), accelerator, chipset processor), I/O controller, memory, or network interface controller.

Reference is now made to the drawings, which are not necessarily drawn to scale, wherein similar or same numbers may be used to designate same or similar parts in different figures. The use of similar or same numbers in different figures does not mean all figures including similar or same numbers constitute a single or same embodiment. Like numerals having different letter suffixes may represent different instances of similar components. The drawings illustrate generally, by way of example, but not by way of limitation, various embodiments discussed in the present document.

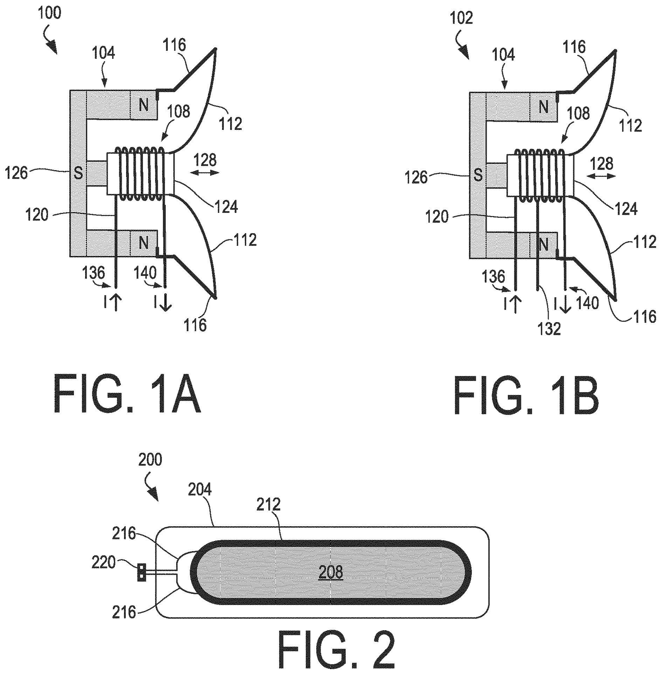

FIGS. 1A-1B are simplified cross-sectional views of example dynamic speakers that can be utilized as RF antennas. FIG. 1A illustrates a dynamic speaker 100 comprising a permanent magnet 104 with north ("N") and south ("S") poles, an electromagnet 108, a cone (or diaphragm) 112, and a frame 116. The electromagnet 108 comprises a speaker coil (or voice coil, coil) 120 wrapped around a core 124. The frame 116 is attached to the permanent magnet 104 and the cone 112. The dynamic speaker 100 produces sound as follows. Current (I) is caused to flow through the speaker coil 120 by, for example, a speaker amplifier, which causes the electromagnet 108 to generate a magnetic field. Interaction between the magnetic fields of the electromagnet 108 and the permanent magnet 104 causes the electromagnet 108 to move away from or towards a base 126 of the permanent magnetic (as indicated by arrow 128), depending on the polarity of the current flowing through the speaker coil 120. Movement of the core 124 causes the cone 112 to move. By alternating the polarity of the current flowing through the speaker coil 120 at the appropriate frequency, movement of the cone 112 can produce audio signals that are detectable by human ears (e.g., sound).

FIG. 1B illustrates a variation 102 of the dynamic speaker 100 of FIG. 1A in which the speaker 102 further comprises a connection 132 (or tap) to the speaker coil 120 at a point between ends 136 and 140 of the speaker coil 120. The point at which the tap 132 is located can be selected to modify the RF frequency range over which the speaker coil 120 exhibits resonance (that is, a frequency range over which the speaker coil 120 transmits RF signals while exhibiting less than a threshold amount of return loss). In some embodiments, the point at which the tap 132 is positioned along the speaker coil 120 can be selected such that the speaker coil exhibits resonance in a desired RFID frequency band.

Speakers 100 and 102 illustrated in FIGS. 1A-1B can take a wide variety of shapes or sizes and be used in a wide variety of mobile computing devices, such as laptops, tablets, smartphones, and wearables. FIG. 2 illustrates a simplified top view of an example speaker module 200 having a low z-profile that can be used as an RF antenna in a laptop or tablet. The speaker module 200 comprises a housing 204, a diaphragm 208, and a speaker coil 212. Wires 216 connect ends of the speaker coil 212 to a two-input connector 220. In some embodiments, the speaker module 200 further comprises a tap to a point along the speaker coil between the ends of the speaker coil and a third wire that connects the tap to a three-input connector

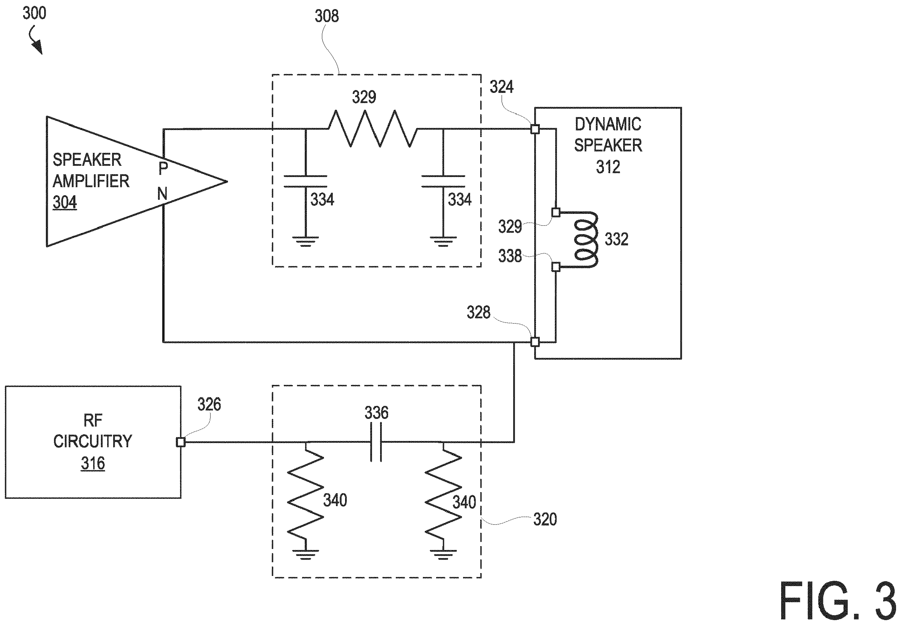

FIG. 3 is a schematic diagram of a first circuit comprising an example dynamic speaker that can be used as an RF antenna. The circuit 300 comprises a speaker amplifier 304, a low-pass filter 308, a dynamic speaker 312, RF circuitry 316, and a high-pass filter 320. The dynamic speaker 312 comprises a speaker coil 332 and first and second speaker inputs 324 and 328. The dynamic speaker 312, as well as any other dynamic speaker described or referenced herein, can be a woofer, tweeter, or any other speaker capable of producing sound and located in a mobile computing device. The speaker amplifier 304 drives the dynamic speaker inputs 324 and 328 from its positive ("P") and negative ("N") outputs and the RF circuitry 316 drives the dynamic speaker 312 and receives signals from the dynamic speaker 312 at an input/output 326.

The RF circuitry 316 can comprise RFID RF front end circuitry. RFID RF front end circuitry can be a discrete component that comprises one or more RF front end circuit components, such as a matching network, modulator, demodulator, and rectifier. In other components RFID RF front end circuitry can be part of an integrated circuit component that implements additional RFID and/or other functionality. In some embodiments, the RFID RF front end is a part of a RFID tag.

The low-pass filter 308 comprises a resistor 329 and a pair of capacitors 334 interconnected as shown in FIG. 3 and is positioned (from a circuit topology standpoint) between the positive ("P") output of the speaker amplifier 304 and the first speaker input 324. The low-pass filter 308 can prevent RF energy generated by the RF circuitry 316 from reaching, and possibly damaging, the output stage of the speaker amplifier 304. In some embodiments, the cut-off frequency of the low-pass filter is about 25 kHz, which is above the upper end of the range of audio signals frequencies that humans can hear (about 20 kHz). In other embodiments, the low-pass filter cut-off frequency can be a frequency other than 25 kHz and that is still greater than about 20 kHz.

The high-pass filter 320 comprises a capacitor 336 and a pair of resistors 340 interconnected as shown in FIG. 3 and is positioned (from a circuit topology standpoint) between, the input/output 326 of the RF circuitry 316 and the input 328 of the dynamic speaker 312. The high-pass filter 320 can prevent audio signal energy generated by the speaker amplifier 304 from reaching, and possibly damaging, the RF circuitry 316. The RF circuitry 316 can drive input 324 or 328 of the dynamic speaker 312. That is, in some embodiments, the high-pass filter 320 can be positioned between the input/output 326 of the RF circuitry 316 and input 328 of the dynamic speaker 312. In some embodiments, the cut-off frequency of the high-pass filter is at a frequency lower than the lower end of an RF frequency band at which RF signals are to be generated by the speaker coil. For example, if a mobile computing device is using the speaker coil to transmit RF signals in the 856-858 MHz RFID frequency band, the high-pass filter can be designed to have a cut-off frequency of about 820 MHz.

In other embodiments, the low-pass filter 308 and/or the high-pass filter 320 can comprise a low-pass filter or high-pass filter, respectively, having a circuit topography different than those shown in FIGS. 3-4. Further, in some embodiments, the low-pass filter 308 can be a discrete integrated circuit component or implemented with individual discrete electronic components (e.g., individual resistors, capacitors, inductors) mounted on a printed circuit board. The high-pass filter 320 can be similarly implemented in various embodiments. Moreover, in some embodiments, the low-pass filter 308 can be integrated in the same integrated circuit component as the speaker amplifier 304, with the low-pass filter conductively coupled to one of the speaker amplifier outputs. Likewise, in some embodiments, the high-pass filter 320 can be implemented in the same integrated circuit component as the RF circuitry, with the high-pass filter conductively coupled to the RF circuitry input/output (e.g., 326). In some embodiments, no low-pass filter is positioned between a speak amplifier and a dynamic speaker. In other embodiments, no high-pass filter is positioned between RF circuitry and a dynamic speaker.

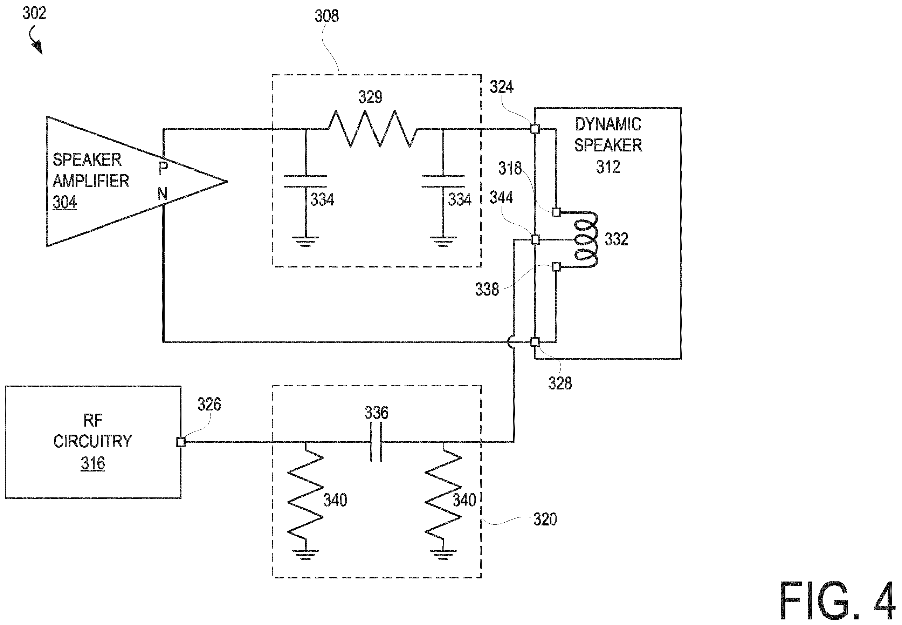

In some embodiments, the speaker coil of a dynamic speaker can cause RF signals to be transmitted efficiently (that is, the dynamic speaker is exhibiting resonance when transmitting the RF signals) in a desired RF frequency band by conductively coupling the RF circuitry (e.g., RF input/output 326) to one of the dynamic speaker inputs to which the speaker amplifier is conductively coupled. That is, the dynamic speaker is capable of exhibiting resonance when transmitting RF signals over a desired RF frequency when the RF circuitry is conductively coupled to one of the dynamic speaker's inputs meant for connection to a speaker amplifier. In other embodiments, such as illustrated in FIG. 4, the RF circuitry is conductively coupled to the speaker coil at a point (or tap) between the ends of the speaker coil. The point along the speaker coil at which the RF circuitry is conductively coupled is chosen to cause the speaker coil to efficiently transit RF signals in a desired RF frequency band when the speaker coil is driven by the RF circuitry.

FIG. 4 is a schematic diagram of a second circuit comprising an example dynamic speaker that can be used as an RF antenna. The circuit 302 is a variation of the circuit 300 with the dynamic speaker 312 having a third input 344 that provides a conductively coupled connection from the third input 344 to a point (or tap) on the speaker coil 332 between the ends of the coil 318 and 338. The input/output 326 of the RF circuitry 316 is conductively coupled to the third input 344 of the dynamic speaker. The point along the speaker coil 332 at which the tap is located can depend on the RF frequency band at which the speaker coil 332 is to transmit RF signals.

In some embodiments, any of the dynamic speakers disclosed herein can transmit and receive RF signals in a frequency band above 100 kHz. In some embodiments, the dynamic speaker can transmit RF signals at any RFID frequency band, such as the 120-150 kHz low frequency (LF) band, the 13.56 MHz high frequency (HF) ISM (industrial, scientific, and medical) band, the 433 MHz ultra-high frequency (UHF) band, the 856-868 MHz or 902-928 MHz ultra-high frequency (UHF) ISM band, the 2.45-5.80 GHz ISM band, or the 3.1-10 GHz ultra-wide band. In other embodiments, the dynamic speaker can produce RF signals in a near-field communication (NFC) frequency band, such as the 13.56 MHz ISM band.

The dynamic speakers capable of producing sound, and transmitting and receiving RF signals above 100 kHz can be attached to a printed circuit board (or motherboard, mainboard). In some embodiments, one or more integrated circuit components or other components (e.g., battery, processor unit) can be attached to the printed circuit board. In some embodiments, the printed circuit board to which the dynamic speaker is attached can be located in a mobile computing device that comprises a housing that encloses the printed circuit board and the dynamic speaker.

In some embodiments, the speaker amplifier, RF circuitry, and the dynamic speaker illustrated in FIGS 3-4 are implemented as separate components. In other embodiments, two or more of these components can be combined into a single component.

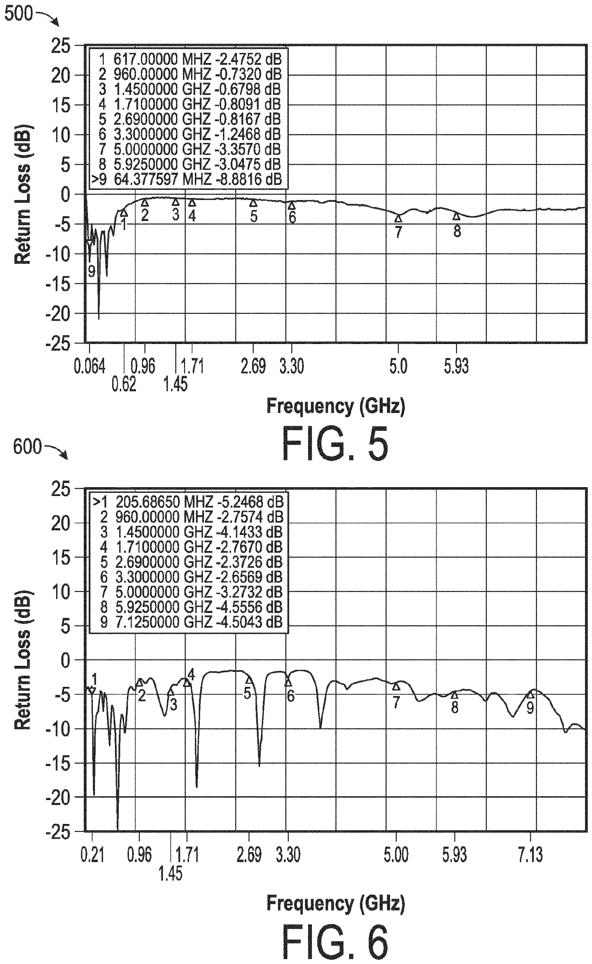

FIG. 5 is a graph showing return loss versus frequency for an example speaker coil for an example tablet computing device. Graph 500 illustrates that the tablet speaker coil exhibits resonance up to about 617 MHz and thus may be used as an RFID antenna without adding a tap along the speaker coil for the lower RFID frequency bands (e.g., 120-150 kHz, 13.56 MHz, 433 MHz). If the tablet speaker coil is desired to be used as an RFID antenna for higher RFID frequency bands (e.g., 865-868 MHz, 902-928 MHz, 2.45-5.8 GHz, 3.1-10 GHz), a tap would need to be added at an appropriate location along the tablet speaker coil.

FIG. 6 is a graph showing return loss versus frequency for an example speaker coil for an example laptop computing device. As can be seen in the graph 600, the laptop speaker coil resonance extends up to 8 GHz and the speaker coil can thus be used as an RF antenna for RFID frequency bands having frequencies below 8 GHz without the need for a tap along the length of the coil.

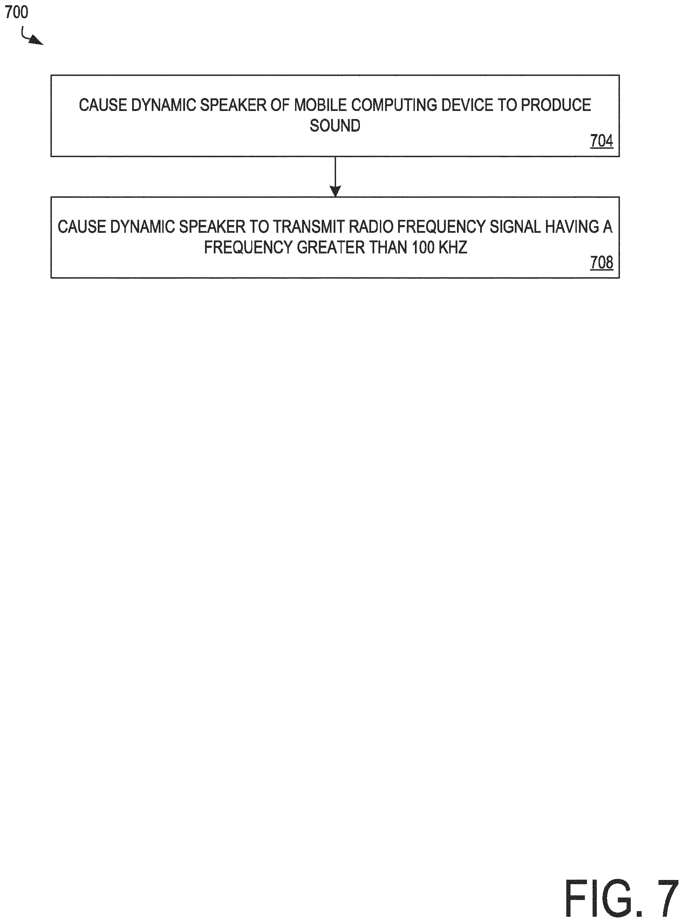

FIG. 7 is an example method of utilizing a dynamic speaker to produce sound, and to transmit and receive RF signals having a frequency greater than about 100 kHz. The method 700 can be performed by, for example, a laptop, a tablet, a smartphone, or a wearable device. At 704 in the method 700, a dynamic speaker of a mobile computing device is caused to produce sound. At 708, the dynamic speaker is caused to transmit a radio frequency signal having a frequency greater than about 100 kHz.

The technologies described herein can be performed by or implemented in any of a variety of mobile computing systems, such as, smartphones, handheld computers, tablet computers, laptop computers, portable gaming consoles, 2-in-1 convertible computers, portable all-in-one computers. The technologies described herein can be utilized in non-mobile computing systems (e.g., desktop computers, servers, workstations, stationary gaming consoles, set-top boxes, smart televisions, rack-level computing solutions (e.g., blade, tray, or sled computing systems)), and embedded computing systems (e.g., computing systems that are part of a vehicle, smart home appliance, consumer electronics product or equipment, manufacturing equipment). As used herein, the term "computing system" includes computing devices and includes systems comprising multiple discrete physical components. In some embodiments, the computing systems are located in a data center, such as an enterprise data center (e.g., a data center owned and operated by a company and typically located on company premises), managed services data center (e.g., a data center managed by a third party on behalf of a company), a colocated data center (e.g., a data center in which data center infrastructure is provided by the data center host and a company provides and manages their own data center components (servers, etc.)), cloud data center (e.g., a data center operated by a cloud services provider that host companies applications and data), and an edge data center (e.g., a data center, typically having a smaller footprint than other data center types, located close to the geographic area that it serves).

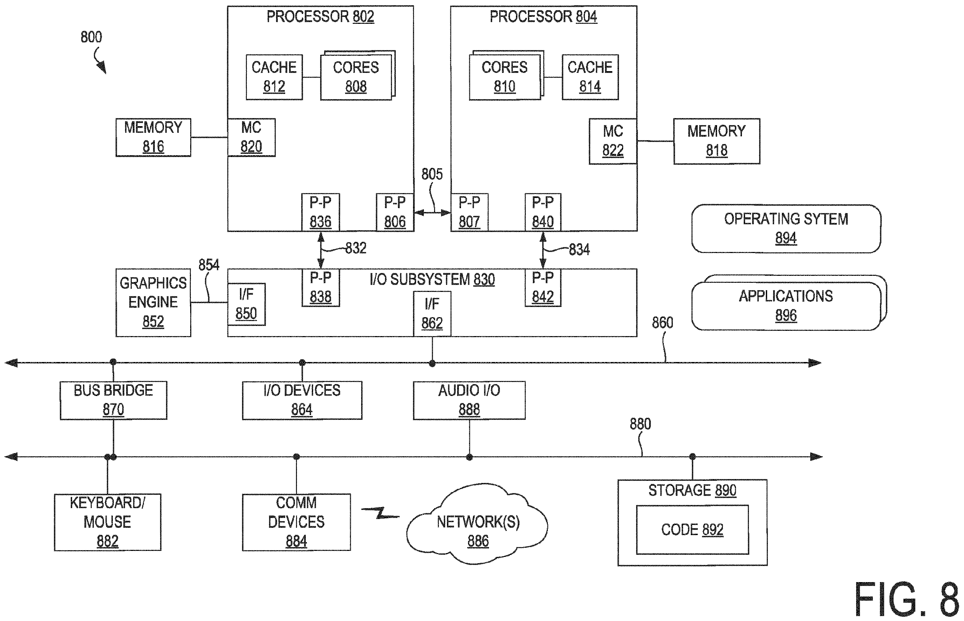

FIG. 8 is a block diagram of an example computing system within which the technologies described herein can be utilized. Generally, components shown in FIG. 8 can communicate with other shown components, although not all connections are shown, for ease of illustration. The computing system 800 is a multiprocessor system comprising a first processor unit 802 and a second processor unit 804 comprising point-to-point (P-P) interconnects. A point-to-point (P-P) interface 806 of the processor unit 802 is coupled to a point-to-point interface 807 of the processor unit 804 via a point-to-point interconnection 805. It is to be understood that any or all of the point-to-point interconnects illustrated in FIG. 8 can be alternatively implemented as a multi-drop bus, and that any or all buses illustrated in FIG. 8 could be replaced by point-to-point interconnects.

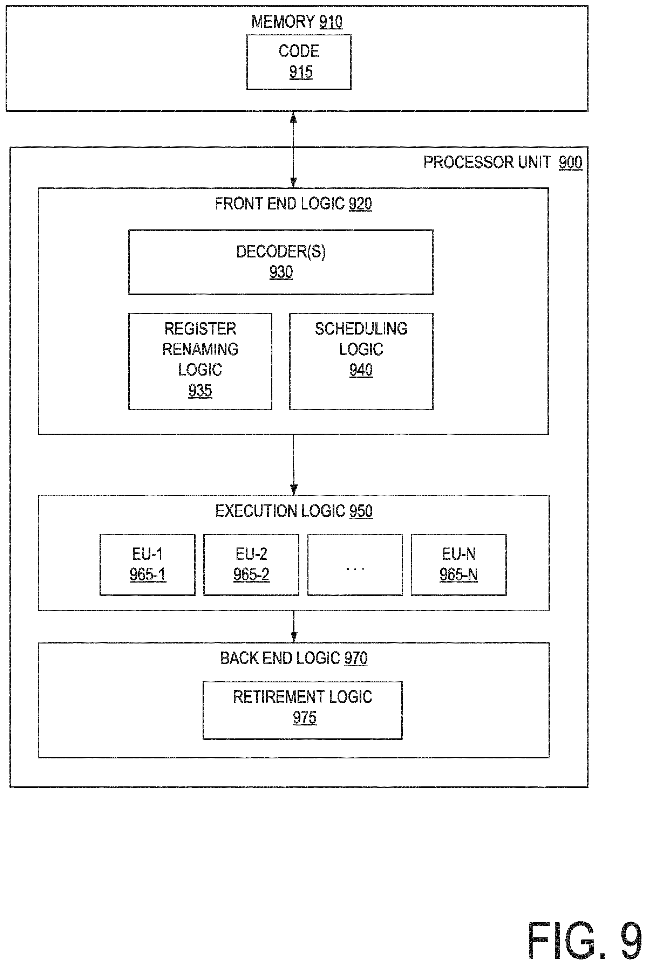

The processor units 802 and 804 comprise multiple processor cores. Processor unit 802 comprises processor cores 808 and processor unit 804 comprises processor cores 810. Processor cores 808 and 810 can execute computer-executable instructions in a manner similar to that discussed below in connection with FIG. 9, or other manners.

Processor units 802 and 804 further comprise cache memories 812 and 814, respectively. The cache memories 812 and 814 can store data (e.g., instructions) utilized by one or more components of the processor units 802 and 804, such as the processor cores 808 and 810. The cache memories 812 and 814 can be part of a memory hierarchy for the computing system 800. For example, the cache memories 812 can locally store data that is also stored in a memory 816 to allow for faster access to the data by the processor unit 802. In some embodiments, the cache memories 812 and 814 can comprise multiple cache levels, such as level 1 (L1), level 2 (L2), level 3 (L3), level 4 (L4) and/or other caches or cache levels. In some embodiments, one or more levels of cache memory (e.g., L2, L3, L4) can be shared among multiple cores in a processor unit or among multiple processor units in an integrated circuit component. In some embodiments, the last level of cache memory on an integrated circuit component can be referred to as a last level cache (LLC). One or more of the higher levels of cache levels (the smaller and faster caches) in the memory hierarchy can be located on the same integrated circuit die as a processor core and one or more of the lower cache levels (the larger and slower caches) can be located on an integrated circuit dies that are physically separate from the processor core integrated circuit dies.

Although the computing system 800 is shown with two processor units, the computing system 800 can comprise any number of processor units. Further, a processor unit can comprise any number of processor cores. A processor unit can take various forms such as a central processing unit (CPU), a graphics processing unit (GPU), general-purpose GPU (GPGPU), accelerated processing unit (APU), field-programmable gate array (FPGA), neural network processing unit (NPU), data processor unit (DPU), accelerator (e.g., graphics accelerator, digital signal processor (DSP), compression accelerator, artificial intelligence (AI) accelerator), controller, or other types of processing units. As such, the processor unit can be referred to as an XPU (or xPU). Further, a processor unit can comprise one or more of these various types of processing units. In some embodiments, the computing system comprises one processor unit with multiple cores, and in other embodiments, the computing system comprises a single processor unit with a single core. As used herein, the terms "processor unit" and "processing unit" can refer to any processor, processor core, component, module, engine, circuitry, or any other processing element described or referenced herein.

In some embodiments, the computing system 800 can comprise one or more processor units that are heterogeneous or asymmetric to another processor unit in the computing system. There can be a variety of differences between the processing units in a system in terms of a spectrum of metrics of merit including architectural, microarchitectural, thermal, power consumption characteristics, and the like. These differences can effectively manifest themselves as asymmetry and heterogeneity among the processor units in a system.

The processor units 802 and 804 can be located in a single integrated circuit component (such as a multi-chip package (MCP) or multi-chip module (MCM)) or they can be located in separate integrated circuit components. An integrated circuit component comprising one or more processor units can comprise additional components, such as embedded DRAM, stacked high bandwidth memory (HBM), shared cache memories (e.g., L3, L4, LLC), input/output (I/O) controllers, or memory controllers. Any of the additional components can be located on the same integrated circuit die as a processor unit, or on one or more integrated circuit dies separate from the integrated circuit dies comprising the processor units. In some embodiments, these separate integrated circuit dies can be referred to as "chiplets". In some embodiments where there is heterogeneity or asymmetry among processor units in a computing system, the heterogeneity or asymmetric can be among processor units located in the same integrated circuit component. In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Processor units 802 and 804 further comprise memory controller logic (MC) 820 and 822. As shown in FIG. 8, MCs 820 and 822 control memories 816 and 818 coupled to the processor units 802 and 804, respectively. The memories 816 and 818 can comprise various types of volatile memory (e.g., dynamic random-access memory (DRAM), static random-access memory (SRAM)) and/or non-volatile memory (e.g., flash memory, chalcogenide-based phase-change non-volatile memories), and comprise one or more layers of the memory hierarchy of the computing system. While MCs 820 and 822 are illustrated as being integrated into the processor units 802 and 804, in alternative embodiments, the MCs can be external to a processor unit.

Processor units 802 and 804 are coupled to an Input/Output (I/O) subsystem 830 via point-to-point interconnections 832 and 834. The point-to-point interconnection 832 connects a point-to-point interface 836 of the processor unit 802 with a point-to-point interface 838 of the I/O subsystem 830, and the point-to-point interconnection 834 connects a point-to-point interface 840 of the processor unit 804 with a point-to-point interface 842 of the I/O subsystem 830. Input/Output subsystem 830 further includes an interface 850 to couple the I/O subsystem 830 to a graphics engine 852. The I/O subsystem 830 and the graphics engine 852 are coupled via a bus 854.

The Input/Output subsystem 830 is further coupled to a first bus 860 via an interface 862. The first bus 860 can be a Peripheral Component Interconnect Express (PCIe) bus or any other type of bus. Various I/O devices 864 can be coupled to the first bus 860. A bus bridge 870 can couple the first bus 860 to a second bus 880. In some embodiments, the second bus 880 can be a low pin count (LPC) bus. Various devices can be coupled to the second bus 880 including, for example, a keyboard/mouse 882, audio I/O devices 888, and a storage device 890, such as a hard disk drive, solid-state drive, or another storage device for storing computer-executable instructions (code) 892 or data. The code 892 can comprise computer-executable instructions for performing methods described herein. Additional components that can be coupled to the second bus 880 include communication device(s) 884, which can provide for communication between the computing system 800 and one or more wired or wireless networks 886 (e.g. Wi-Fi, cellular, or satellite networks) via one or more wired or wireless communication links (e.g., wire, cable, Ethernet connection, radio-frequency (RF) channel, infrared channel, Wi-Fi channel) using one or more communication standards (e.g., IEEE 802.11 standard and its supplements).

In embodiments where the communication devices 884 support wireless communication, the communication devices 884 can comprise wireless communication components coupled to one or more antennas to support communication between the computing system 800 and external devices. The wireless communication components can support various wireless communication protocols and technologies such as Near Field Communication (NFC), IEEE 1002.11 (Wi-Fi) variants, WiMax, Bluetooth, Zigbee, 4G Long Term Evolution (LTE), Code Division Multiplexing Access (CDMA), Universal Mobile Telecommunication System (UMTS) and Global System for Mobile Telecommunication (GSM), and 5G broadband cellular technologies. In addition, the wireless modems can support communication with one or more cellular networks for data and voice communications within a single cellular network, between cellular networks, or between the computing system and a public switched telephone network (PSTN).

The system 800 can comprise removable memory such as flash memory cards (e.g., SD (Secure Digital) cards), memory sticks, Subscriber Identity Module (SIM) cards). The memory in system 800 (including caches 812 and 814, memories 816 and 818, and storage device 890) can store data and/or computer-executable instructions for executing an operating system 894 and application programs 896. Example data includes web pages, text messages, images, sound files, and video data to be sent to and/or received from one or more network servers or other devices by the system 800 via the one or more wired or wireless networks 886, or for use by the system 800. The system 800 can also have access to external memory or storage (not shown) such as external hard drives or cloud-based storage.

The operating system 894 can control the allocation and usage of the components illustrated in FIG. 8 and support the one or more application programs 896. The application programs 896 can include common computing system applications (e.g., email applications, calendars, contact managers, web browsers, messaging applications) as well as other computing applications.

The computing system 800 can support various additional input devices, such as a touchscreen, microphone, monoscopic camera, stereoscopic camera, trackball, touchpad, trackpad, proximity sensor, or light sensor, and one or more output devices, such as one or more speakers or displays. Other possible input and output devices include piezoelectric and other haptic I/O devices. Any of the input or output devices can be internal to, external to, or removably attachable with the system 800. External input and output devices can communicate with the system 800 via wired or wireless connections.

The system 800 can further include at least one input/output port comprising physical connectors (e.g., USB, IEEE 1394 (FireWire), Ethernet, RS-232), a power supply (e.g., battery), a global satellite navigation system (GNSS) receiver (e.g., GPS receiver); a gyroscope; an accelerometer; and/or a compass. A GNSS receiver can be coupled to a GNSS antenna. The computing system 800 can further comprise one or more additional antennas coupled to one or more additional receivers, transmitters, and/or transceivers to enable additional functions.

It is to be understood that FIG. 8 illustrates only one example computing system architecture. Computing systems based on alternative architectures can be used to implement technologies described herein. For example, instead of the processors 802 and 804 and the graphics engine 852 being located on discrete integrated circuits, a computing system can comprise an SoC (system-on-a-chip) integrated circuit incorporating multiple processors, a graphics engine, and additional components. Further, a computing system can connect its constituent component via bus or point-to-point configurations different from that shown in FIG. 8. Moreover, the illustrated components in FIG. 8 are not required or all-inclusive, as shown components can be removed and other components added in alternative embodiments.

FIG. 9 is a block diagram of an example processor unit 900 to execute computer-executable instructions as part of implementing technologies described herein. The processor unit 900 can be a single-threaded core or a multithreaded core in that it may include more than one hardware thread context (or "logical processor") per processor unit.

FIG. 9 also illustrates a memory 910 coupled to the processor unit 900. The memory 910 can be any memory described herein or any other memory known to those of skill in the art. The memory 910 can store computer-executable instructions 915 (code) executable by the processor unit 900.

The processor unit comprises front-end logic 920 that receives instructions from the memory 910. An instruction can be processed by one or more decoders 930. The decoder 930 can generate as its output a micro-operation such as a fixed width micro operation in a predefined format, or generate other instructions, microinstructions, or control signals, which reflect the original code instruction. The front-end logic 920 further comprises register renaming logic 935 and scheduling logic 940, which generally allocate resources and queues operations corresponding to converting an instruction for execution.

The processor unit 900 further comprises execution logic 950, which comprises one or more execution units (EUs) 965 (965-1 through 965-N). Some processor unit embodiments can include a number of execution units dedicated to specific functions or sets of functions. Other embodiments can include only one execution unit or one execution unit that can perform a particular function. The execution logic 950 performs the operations specified by code instructions. After completion of execution of the operations specified by the code instructions, back-end logic 970 retires instructions using retirement logic 975. In some embodiments, the processor unit 900 allows out of order execution but requires in-order retirement of instructions. Retirement logic 975 can take a variety of forms as known to those of skill in the art (e.g., reorder buffers or the like).

The processor unit 900 is transformed during execution of instructions, at least in terms of the output generated by the decoder 930, hardware registers and tables utilized by the register renaming logic 935, and any registers (not shown) modified by the execution logic 950.

As used herein, the term "circuitry" can comprise, singly or in any combination, non-programmable (hardwired) circuitry, programmable circuitry such as processor units, state machine circuitry, and/or firmware that stores instructions executable by programmable circuitry. Modules or components described herein may, collectively or individually, be embodied as circuitry that forms a part of a computing system. Thus, any of the modules can be implemented as circuitry, such as speaker amplifier circuitry, RFID RF front end circuitry, and dynamic speaker circuitry. A computing system referred to as being programmed to perform a method can be programmed to perform the method via software, hardware, firmware, or combinations thereof.

Any of the disclosed methods (or a portion thereof) can be implemented as computer-executable instructions or a computer program product. Such instructions can cause a computing system or one or more processor units capable of executing computer-executable instructions to perform any of the disclosed methods. As used herein, the term "computer" refers to any computing system, device, or machine described or mentioned herein as well as any other computing system, device, or machine capable of executing instructions. Thus, the term "computer-executable instruction" refers to instructions that can be executed by any computing system, device, or machine described or mentioned herein as well as any other computing system, device, or machine capable of executing instructions.

The computer-executable instructions or computer program products as well as any data created and/or used during implementation of the disclosed technologies can be stored on one or more tangible or non-transitory computer-readable storage media, such as volatile memory (e.g., DRAM, SRAM), non-volatile memory (e.g., flash memory, chalcogenide-based phase-change non-volatile memory) optical media discs (e.g., DVDs, CDs), and magnetic storage (e.g., magnetic tape storage, hard disk drives). Computer-readable storage media can be contained in computer-readable storage devices such as solid-state drives, USB flash drives, and memory modules. Alternatively, any of the methods disclosed herein (or a portion) thereof may be performed by hardware components comprising non-programmable circuitry. In some embodiments, any of the methods herein can be performed by a combination of non-programmable hardware components and one or more processing units executing computer-executable instructions stored on computer-readable storage media.

The computer-executable instructions can be part of, for example, an operating system of the computing system, an application stored locally to the computing system, or a remote application accessible to the computing system (e.g., via a web browser). Any of the methods described herein can be performed by computer-executable instructions performed by a single computing system or by one or more networked computing systems operating in a network environment. Computer-executable instructions and updates to the computer-executable instructions can be downloaded to a computing system from a remote server.

Further, it is to be understood that implementation of the disclosed technologies is not limited to any specific computer language or program. For instance, the disclosed technologies can be implemented by software written in C++, C#, Java, Perl, Python, JavaScript, Adobe Flash, C#, assembly language, or any other programming language. Likewise, the disclosed technologies are not limited to any particular computer system or type of hardware.

Furthermore, any of the software-based embodiments (comprising, for example, computer-executable instructions for causing a computer to perform any of the disclosed methods) can be uploaded, downloaded, or remotely accessed through a suitable communication means. Such suitable communication means include, for example, the Internet, the World Wide Web, an intranet, cable (including fiber optic cable), magnetic communications, electromagnetic communications (including RF, microwave, ultrasonic, and infrared communications), electronic communications, or other such communication means.

As used in this application and the claims, a list of items joined by the term "and/or" can mean any combination of the listed items. For example, the phrase "A, B and/or C" can mean A; B; C; A and B; A and C; B and C; or A, B and C. As used in this application and the claims, a list of items joined by the term "at least one of" can mean any combination of the listed terms. For example, the phrase "at least one of A, B or C" can mean A; B; C; A and B; A and C; B and C; or A, B, and C. Moreover, as used in this application and the claims, a list of items joined by the term "one or more of" can mean any combination of the listed terms. For example, the phrase "one or more of A, B and C" can mean A; B; C; A and B; A and C; B and C; or A, B, and C.

As used in this application and the claims, the phrase "individual of" or "respective of" following by a list of items recited or stated as having a trait, feature, etc. means that all of the items in the list possess the stated or recited trait, feature, etc. For example, the phrase "individual of A, B, or C, comprise a sidewall" or "respective of A, B, or C, comprise a sidewall" means that A comprises a sidewall, B comprises sidewall, and C comprises a sidewall.

The disclosed methods, apparatuses, and systems are not to be construed as limiting in any way. Instead, the present disclosure is directed toward all novel and nonobvious features and aspects of the various disclosed embodiments, alone and in various combinations and subcombinations with one another. The disclosed methods, apparatuses, and systems are not limited to any specific aspect or feature or combination thereof, nor do the disclosed embodiments require that any one or more specific advantages be present or problems be solved.

Theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

Although the operations of some of the disclosed methods are described in a particular, sequential order for convenient presentation, it is to be understood that this manner of description encompasses rearrangement, unless a particular ordering is required by specific language set forth herein. For example, operations described sequentially may in some cases be rearranged or performed concurrently. Moreover, for the sake of simplicity, the attached figures may not show the various ways in which the disclosed methods can be used in conjunction with other methods.

The following examples pertain to additional embodiments of technologies disclosed herein.

Example 1 is an apparatus comprising a dynamic speaker comprising a speaker coil; a speaker amplifier to cause the dynamic speaker to produce sound; and radio frequency (RF) circuitry to cause the speaker coil to transmit a radio frequency signal having a frequency greater than about 100 kHz.

Example 2 includes the subject matter of Example 1, and wherein the speaker amplifier comprises a first speaker amplifier output and a second speaker amplifier output, the RF circuitry comprises an RF input/output, the dynamic speaker further comprising a first speaker input conductively coupled to a first end of the speaker coil; and a second speaker input conductively coupled to a second end of the speaker coil; wherein the first speaker amplifier output is conductively coupled to the first speaker input, the second speaker amplifier output is conductively coupled to the second speaker input, and the RF input/output is conductively coupled to the first speaker input or the second speaker input.

Example 3 includes the subject matter of Examples 1 and 2, and wherein the speaker amplifier comprises a first speaker amplifier output and a second speaker amplifier output, the RF circuitry comprises an RF input/output, the dynamic speaker further comprising a first speaker input conductively coupled to a first end of the speaker coil; a second speaker input conductively coupled to a second end of the speaker coil; and a third speaker input conductively coupled to a point along the speaker coil between the first end of the speaker coil and the second end of the speaker coil; wherein the first speaker amplifier output is conductively coupled to the first speaker input, the second speaker amplifier output is connected to the second speaker input, and the RF input/output is conductively coupled to the third speaker input.

Example 4 includes the subject matter of Example 2 or 3, further comprising a low-pass filter positioned between the first speaker amplifier output and the first speaker input.

Example 5 includes the subject matter of Example 2 or 3, further comprising a high-pass filter, positioned between the RF input/output and the first speaker input or the second speaker input.

Example 6 includes the subject matter of Example 2 or 3, wherein the speaker amplifier comprises a low-pass filter conductively coupled to the first speaker amplifier output.

Example 7 includes the subject matter of Example 2 or 3, wherein the RF circuitry comprises a high-pass filter conductively coupled to the RF input/output.

Example 8 includes the subject matter of any one of Examples 1-7, wherein the frequency of the radio frequency signal is within an RFID frequency band.

Example 9 includes the subject matter of any one of Examples 1-7, wherein the frequency of the radio frequency signal is within a near-field communication frequency band.

Example 10 includes the subject matter of any one of Examples 1-7, wherein the frequency of the radio frequency signal is within about 120 to about 150 kHz.

Example 11 includes the subject matter of any one of Examples 1-7, wherein the frequency of the radio frequency signal is about 13.56 MHz.

Example 12 includes the subject matter of any one of Examples 1-7, wherein the frequency of the radio frequency signal is about 433 MHz.

Example 13 includes the subject matter of any one of Examples 1-7, wherein the frequency of the radio frequency signal is within about 856 to about 868 MHz.

Example 14 includes the subject matter of any one of Examples 1-7, wherein the frequency of the radio frequency signal is within about 902 to about 928 Mhz.

Example 15 includes the subject matter of any one of Examples 1-14, wherein the apparatus is a mobile computing device.

Example 16 includes the subject matter of any one of Examples 1-15, wherein the RF circuitry is part of an RFID tag.

Example 17 includes the subject matter of any one of Examples 1-16, wherein the apparatus further comprises a battery.

Example 18 is a method comprising causing a dynamic speaker of a mobile computing device to produce sound; and causing a coil of the dynamic speaker to transmit a radio frequency signal having a frequency greater than about 100 kHz.

Example 19 includes the subject matter of Example 18, and wherein the frequency of the radio frequency signal is within an RFID frequency band.

Example 20 includes the subject matter of Example 18, and wherein the frequency of the radio frequency signal is within a near-field communication frequency band.

Example 21 includes the subject matter of Example 18, and wherein the frequency of the radio frequency signal is within about 120 to about 150 kHz.

Example 22 includes the subject matter of Example 18, and wherein the frequency of the radio frequency signal is about 13.56 MHz.

Example 23 includes the subject matter of Example 18, and wherein the frequency of the radio frequency signal is about 433 MHz.

Example 24 includes the subject matter of Example 18, and wherein the frequency of the radio frequency signal is within about 856 to about 868 MHz.

Example 25 includes the subject matter of Example 18, and wherein the frequency of the radio frequency signal is within about 902 to about 928 Mhz.

Example 26 includes one or more computer-readable storage media implementing the method of any one of Examples 18-25.

Example 27 includes an apparatus comprising a means to perform the method of any one of Examples 18-25.

Example 28 includes an apparatus, comprising a transmitting means to produce sound and to transmit a radio frequency signal having a frequency greater than about 100 kHz; a speaker amplifier to cause the transmitting means to produce the sound; and radio frequency (RF) circuitry to cause the transmitting means to transmit the radio frequency signal.

Example 29 includes the subject matter of Example 28, and wherein the speaker amplifier comprises a low-pass filter conductively coupled to an output of the speaker amplifier, the output of the speaker amplifier conductively coupled to the transmitting means.

Example 30 includes the subject matter of Example 28, and wherein the RF circuitry comprises a high-pass filter conductively coupled to an input/output of the RF circuitry, the output of the RF circuitry conductively coupled to the transmitting means.

Example 31 includes the subject matter of Example 28, and wherein the frequency of the radio frequency signal is within an RFID frequency band.

Example 32 includes the subject matter of Example 28, and wherein the frequency of the radio frequency signal is within a near-field communication frequency band.

Example 33 includes the subject matter of Example 28, and wherein the frequency of the radio frequency signal is within about 120 to about 150 kHz.

Example 34 includes the subject matter of Example 28, and wherein the frequency of the radio frequency signal is about 13.56 MHz.

Example 35 includes the subject matter of Example 28, and wherein the frequency of the radio frequency signal is about 433 MHz.

Example 36 includes the subject matter of Example 28, and wherein the frequency of the radio frequency signal is within about 856 to about 868 MHz.

Example 37 includes the subject matter of Example 28, and wherein the frequency of the radio frequency signal is within about 902 to about 928 Mhz.

Example 38 includes the subject matter of any one of Examples 28-37, wherein the apparatus is a mobile computing device.

Example 39 includes the subject matter of any one of Examples 28-38, wherein the apparatus further comprises a battery.

## Claims

1. An apparatus comprising:
a dynamic speaker comprising a speaker coil;
a speaker amplifier to cause the dynamic speaker to produce sound; and
radio frequency circuitry (RF circuitry) to cause the speaker coil to transmit a radio frequency signal having a frequency greater than about 100 kHz.

2. The apparatus of claim 1, wherein the speaker amplifier comprises a first speaker amplifier output and a second speaker amplifier output, the RF circuitry comprises an RF input/output, the dynamic speaker further comprising:
a first speaker input conductively coupled to a first end of the speaker coil; and
a second speaker input conductively coupled to a second end of the speaker coil;
wherein the first speaker amplifier output is conductively coupled to the first speaker input, the second speaker amplifier output is conductively coupled to the second speaker input, and the RF input/output is conductively coupled to the first speaker input or the second speaker input.

3. The apparatus of claim 1 or 2, wherein the speaker amplifier comprises a first speaker amplifier output and a second speaker amplifier output, the RF circuitry comprises an RF input/output, the dynamic speaker further comprising:
a first speaker input conductively coupled to a first end of the speaker coil;
a second speaker input conductively coupled to a second end of the speaker coil; and
a third speaker input conductively coupled to a point along the speaker coil between the first end of the speaker coil and the second end of the speaker coil;
wherein the first speaker amplifier output is conductively coupled to the first speaker input, the second speaker amplifier output is connected to the second speaker input, and the RF input/output is conductively coupled to the third speaker input.

4. The apparatus of any one of claims 1-3, wherein the apparatus is a mobile computing device and the frequency of the radio frequency signal is within an RFID frequency band.

5. The apparatus of any one of claims 1-4, wherein the apparatus further comprises a battery.

6. A method comprising:
causing a dynamic speaker of a mobile computing device to produce sound; and
causing a coil of the dynamic speaker to transmit a radio frequency signal having a frequency greater than about 100 kHz.

7. The method of claim 6, wherein the frequency of the radio frequency signal is within an RFID frequency band.

8. The method of claim 6, wherein the frequency of the radio frequency signal is within a near-field communication frequency band.

9. The method of claim 6, wherein the frequency of the radio frequency signal is within about 120 to about 150 kHz.

10. The method of claim 6, wherein the frequency of the radio frequency signal is about 13.56 MHz.

11. The method of claim 6, wherein the frequency of the radio frequency signal is about 433 MHz.

12. The method of claim 6, wherein the frequency of the radio frequency signal is within about 856 to about 868 MHz.

13. The method of claim 6, wherein the frequency of the radio frequency signal is within about 902 to about 928 Mhz.

14. One or more computer-readable storage media having instructions that, when executed, cause a mobile computing device to implement the method of any one of claims 6-13.

15. An apparatus comprising a means to perform any the method of any one of claims 6-14. 16.
